# EUROPÄISCHE PATENTANMELDUNG

(11) **EP 3 584 751 A1**
(43) Veröffentlichungstag der Anmeldung: **25.12.2019**
(21) Anmeldenummer: 18178790.4
(22) Anmeldetag: 20.06.2018
(51) Int. Cl.: G06Q 10/06

(54) **VERFAHREN ZUM ERSTELLEN EINES DIGITALEN ZWILLINGS**

(71) Anmelder: Siemens Aktiengesellschaft, 80333 München (DE)
(72) Erfinder: Lehner, Johannes, 95444 Bayreuth (DE)

(57) **Zusammenfassung**

Die Erfindung ist ein Verfahren zum Erstellen eines als digitaler Zwilling (12) eines technischen Produkts (10) fungierenden Softwareobjekts auf Basis von gegebenen Produktwissen (20), wobei das Produktwissen (20) in einer automatisch verarbeitbaren Form zur Verfügung steht und als Objektvarianten (22) Datensätze mit Daten für unterschiedliche Varianten zumindest einer Komponente des technischen Produkts (10) umfasst, wobei den Objektvarianten (22) jeweils eine als eindeutige Kennung fungierende Objektvariantenklassifikation (24) sowie Geometriedaten (30) und Positionsdaten (32) zugeordnet sind, wobei jede Objektvariante (22), deren Objektvariantenklassifikation (24) zu einem vorgegebenen oder vorgebbaren Artikelcode (40) passt, als zum digitalen Zwilling (12) gehörig verarbeitet wird und wobei für jede zum digitalen Zwilling (12) gehörige Objektvariante (22) eine Positionierung des oder jedes mittels der Geometriedaten (30) der jeweiligen Objektvariante (22) beschriebenen geometrischen Objekts entsprechend der Positionsdaten (32) der jeweiligen Objektvariante (22) erfolgt.

## Beschreibung

Die Erfindung betrifft ein Verfahren zum Erstellen eines digitalen Zwillings eines technischen Produkts. Ein digitaler Zwilling ist ein Softwareobjekt, welches das jeweilige technische Produkt repräsentiert.

Im Zeitalter von Industrie 4.0 entstehen ständig wachsende Anforderungen an die direkten und indirekten Leistungen eines technischen Produkts. Neben den direkten technischen Merkmalen eines Produkts, zum Beispiel Bauraum oder Leistung, muss auch den indirekten Merkmalen zunehmende Beachtung geschenkt werden. Hierzu zählt, dass im industriellen Umfeld ein Kunde heutzutage erwartet, beim Kauf eines technischen Produkts neben Daten zu dessen Gewicht, Schwerpunkt und Maßbild auch seinen digitalen Zwilling zu erhalten, der beispielsweise zur Anlagenplanung herangezogen werden kann.

Eine Aufgabe der Erfindung besteht darin, ein besonders einfaches Verfahren zum Erstellen eines digitalen Zwillings anzugeben.

Diese Aufgabe wird erfindungsgemäß mittels eines Verfahrens mit den Merkmalen des Anspruchs 1 gelöst. Dabei ist zum Erstellen eines als digitaler Zwilling eines technischen Produkts fungierenden Softwareobjekts Folgendes vorgesehen:
Das Erstellen des digitalen Zwillings erfolgt auf Basis von gegebenem Produktwissen. Dieses steht in einer automatisch verarbeitbaren Form zur Verfügung. Das Produktwissen umfasst Datensätze mit Daten für unterschiedliche Varianten zumindest einer Komponente des jeweiligen technischen Produkts oder Datensätze mit Daten für unterschiedliche Varianten verschiedener Komponenten unterschiedlicher technischer Produkte. Solche Datensätze werden im Folgenden als Objektvarianten bezeichnet.

Den Objektvarianten ist jeweils eine als eindeutige Kennung fungierende Objektvariantenklassifikation zugeordnet. Den Objektvarianten sind darüber hinaus jeweils zumindest Geometriedaten und Positionsdaten zugeordnet.

Zur Erstellung des digitalen Zwillings eines technischen Produkts wird ein Artikelcode des jeweiligen technischen Produkts zum Beispiel eingegeben oder ausgewählt. Anhand des Artikelcodes erfolgt eine automatische Auswahl einzelner Objektvarianten. Diese Auswahl umfasst für alle vom Produktwissen umfassten Objektvarianten die Prüfung, ob deren Objektvariantenklassifikation und der jeweilige Artikelcode zueinander passen. Immer wenn dies der Fall ist, wird die jeweilige Objektvariante als zum digitalen Zwilling gehörig oder vom digitalen Zwilling umfasst verarbeitet, zum Beispiel indem die Daten der jeweiligen Objektvariante oder wesentliche Daten der Objektvariante dem entstehenden Softwareobjekt, dem digitalen Zwilling, unmittelbar oder mittelbar hinzugefügt werden.

Bei einer Auswertung der Daten des erzeugten digitalen Zwillings erfolgt für jede zum digitalen Zwilling gehörige Objektvariante eine Positionierung des oder jedes mittels der Geometriedaten der jeweiligen Objektvariante beschriebenen geometrischen Objekts entsprechend der Positionsdaten der jeweiligen Objektvariante.

Der Vorteil der Erfindung besteht darin, dass der digitale Zwilling auf Basis des Produktwissens entsteht und auf diese Weise bereits zur Verfügung stehende Daten wiederverwendet werden.

Die Erfindung ist damit eine automatische Extraktion der zum Erstellen eines digitalen Zwillings eines konkreten technischen Produkts erforderlichen Daten aus einer Datenbasis mit Produktwissen. Die Datenbasis umfasst das Produktwissen in Form einer vollständigen Beschreibung des jeweiligen technischen Produkts, zum Beispiel in Form von CAD-Daten. Diese vollständige Beschreibung umfasst auch die vorgenannten Objektvarianten, also zum Beispiel eine Beschreibung unterschiedlicher oder hinsichtlich ihrer Gestaltung und/oder Position variierender Komponenten des jeweiligen Produkts, insbesondere in Form von CAD-Daten. Damit solche Objektvarianten im Rahmen des hier vorgeschlagenen Ansatzes verwendbar und automatisch auffindbar sind, ist lediglich eine Kennzeichnung der jeweiligen Daten mit einer eindeutigen Objektvariantenklassifikation notwendig.

Vorteilhafte Ausgestaltungen der Erfindung sind Gegenstand der Unteransprüche. Dabei verwendete Rückbeziehungen innerhalb der Ansprüche weisen auf die weitere Ausbildung des Gegenstandes des in Bezug genommenen Anspruchs durch die Merkmale des jeweiligen abhängigen Anspruchs hin. Sie sind nicht als ein Verzicht auf die Erzielung eines selbständigen, gegenständlichen Schutzes für die Merkmale oder Merkmalskombinationen eines abhängigen Anspruchs zu verstehen. Des Weiteren ist im Hinblick auf eine Auslegung der Ansprüche sowie der Beschreibung bei einer näheren Konkretisierung eines Merkmals in einem abhängigen Anspruch davon auszugehen, dass eine derartige Beschränkung in den jeweils vorangehenden Ansprüchen sowie einer allgemeineren Ausführungsform des gegenständlichen Verfahrens nicht vorhanden ist. Jede Bezugnahme in der Beschreibung auf Aspekte abhängiger Ansprüche ist demnach auch ohne speziellen Hinweis ausdrücklich als Beschreibung optionaler Merkmale zu lesen.

Bei einer vorteilhaften Ausführungsform des Verfahrens wird unter Berücksichtigung aller zum digitalen Zwilling gehörigen Objektvariantendaten ein Gewichtswert und/oder ein Schwerpunkt ermittelt. Der ermittelte Gewichtswert oder Schwerpunkt entspricht dem Gewichtswert bzw. Schwerpunkt des mittels des digitalen Zwillings repräsentierten technischen Produkts.

Bei einer weiteren Ausführungsform des Verfahrens werden die Objektvariantendaten in dem resultierenden Softwareobjekt, dem digitalen Zwilling, gespeichert. Der digitale Zwilling ist aufgrund der Übernahme der Objektvariantendaten unabhängig von dem Produktwissen und/oder dessen Verfügbarkeit geworden. Der digitale Zwilling, also das Softwareobjekt, kann damit zum Beispiel auch an Dritte weitergegeben werden, die keinen Zugriff auf das Produktwissen haben oder auch gar keinen derartigen Zugriff haben sollen.

Bei einer nochmals weiteren Ausführungsform des Verfahrens fungieren als Objektvariantenklassifikation Ausdrücke in einer formalen Sprache, beispielsweise reguläre Ausdrücke. Die Verwendung von Ausdrücken in einer formalen Sprache, speziell die Verwendung regulärer Ausdrücke, erlaubt die Integration des hier vorgeschlagenen Verfahrens in eine weiterreichende Datenverarbeitung, beispielsweise eine Datenverarbeitung eines Herstellers von Elektromotoren. Die jeweiligen technischen Produkte, also zum Beispiel Elektromotoren, sind innerhalb einer solchen Datenverarbeitung regelmäßig ohnehin in einer maschinenlesbaren Form bezeichnet, insbesondere mittels eines Artikelcodes in Form einer maschinenlesbaren Fabrikatebezeichnung (MLFB). Diese Daten, die zum Beispiel aufgrund von Konstruktionsdaten, beispielsweise CAD-Daten, resultieren, sind als Produktwissen verwendbar. Dies gewährleistet, dass der digitale Zwilling insbesondere hinsichtlich seiner Geometrie und hinsichtlich seiner Maße exakt mit dem jeweils repräsentierten technischen Produkt übereinstimmt.

Das im Folgenden beschriebene Verfahren ist zur automatischen Ausführung bevorzugt in Form eines Computerprogramms realisiert. Die Erfindung ist damit einerseits auch ein Computerprogramm mit durch einen Computer ausführbaren Programmcodeanweisungen und andererseits ein Speichermedium mit einem derartigen Computerprogramm, also ein Computerprogrammprodukt mit Programmcodemitteln, sowie schließlich auch ein grundsätzlich an sich bekannter Computer oder ein grundsätzlich an sich bekanntes Computersystem, in dessen Speicher als Mittel zur Durchführung des Verfahrens und seiner Ausgestaltungen ein solches Computerprogramm geladen oder ladbar ist.

Nachfolgend wird ein Ausführungsbeispiel der Erfindung anhand der Zeichnung näher erläutert. Einander entsprechende Gegenstände oder Elemente sind in allen Figuren mit den gleichen Bezugszeichen versehen. Es zeigen
- FIG 1: ein technisches Produkt,
- FIG 2: einen das technische Produkt in FIG 1 repräsentierenden digitalen Zwilling,
- FIG 3: eine schematisch vereinfachte Veranschaulichung einer Erzeugung eines digitalen Zwillings und
- FIG 4: einen aufgrund einer Generierung gemäß FIG 3 resultierenden digitalen Zwilling.

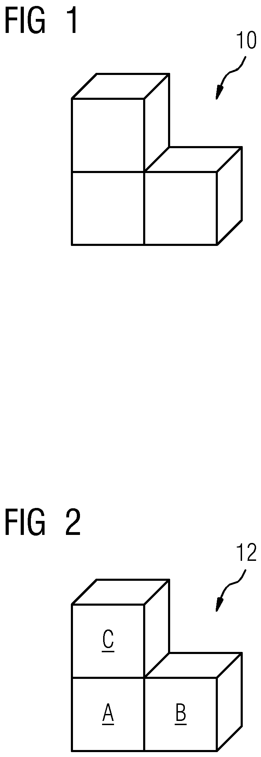

Die Darstellung in FIG 1 zeigt im Interesse einer sprachlich einfachen weiteren Beschreibung ein schematisch stark vereinfachtes reales technisches Produkt 10. Bei dem Produkt 10 handelt es sich zum Beispiel um einen Elektromotor. Genauso kann es sich bei dem Produkt 10 zum Beispiel um ein Sitzmöbel handeln. Auf die Art des Produkts 10 kommt es nicht an.

Zu einem grundsätzlich beliebigen technischen Produkt 10 soll ein sogenannter digitaler Zwilling 12 erstellt werden, also ein Softwareobjekt, welches die wesentlichen Eigenschaften des jeweiligen technischen Produkts 10 beschreibt. Das resultierende Softwareobjekt ist der digitale Zwilling 12 und entsprechend werden die Begriffe digitaler Zwilling 12 und Softwareobjekt synonym benutzt.

Die Darstellung in FIG 2 zeigt einen das technische Produkt 10 in FIG 1 repräsentierenden digitalen Zwilling 12. Die zeichnerischen Darstellungen einerseits des technischen Produkts 10 (FIG 1) und andererseits des diesen repräsentierenden digitalen Zwillings 12 (FIG 2) sind naturgemäß kaum zu unterscheiden. Die Darstellung des digitalen Zwillings 12 in FIG 2 umfasst noch symbolische Bezeichner der von dem digitalen Zwilling 12 umfassten Objekte.

Ersichtlich umfasst das technische Produkt 10 gemäß FIG 1 im dargestellten Beispiel drei einzelne Objekte. Bei diesen handelt es sich vorliegend - aber lediglich exemplarisch - um Würfel. Die Objekte (Würfel) sind in einer konkreten geometrischen Relation zueinander angeordnet: Neben einem ersten Würfel befindet sich ein zweiter Würfel und auf dem ersten Würfel befindest sich ein dritter Würfel. Die drei Würfel sind bei der Darstellung des digitalen Zwillings 12 in FIG 2 symbolisch mit "A" (erster Würfel), "B" (zweiter Würfel) und "C" (dritter Würfel) bezeichnet.

Die Darstellung in FIG 2 zeigt im Grunde bereits das Ergebnis der Erstellung eines digitalen Zwillings 12 zu einem realen technischen Produkt 10. Im Folgenden wird der Weg zum automatischen Erhalt eines solchen digitalen Zwillings 12 beschrieben.

Ein digitaler Zwilling 12 ist - wie bereits der Name sagt - eine datentechnische Entsprechung eines jeweils darzustellenden technischen Produkts 10. Ein digitaler Zwilling 12 ist also im weitesten Sinne ein Datensatz, welcher direkt oder indirekt alle diejenigen Daten umfasst, die zur Beschreibung der relevanten Eigenschaften des technischen Produkts 10, insbesondere der geometrischen Eigenschaften des technischen Produkts 10 und/oder damit in Verbindung stehender Eigenschaften, notwendig sind. Bei diesen relevanten technischen Eigenschaften handelt es sich zum Beispiel um die Maße des technischen Produkts 10, eine Dimension einer Hüllkontur um das technische Produkt 10, das Gewicht des technischen Produkts 10, einen Schwerpunkt des technischen Produkts 10 und so weiter.

Zum Anlegen datentechnischer Entsprechungen der von dem zu repräsentierenden technischen Produkt 10 umfassten physikalischen Objekte innerhalb des digitalen Zwillings 12 könnten dafür theoretisch einzelne Objekte angelegt werden, zum Beispiel einzeln mittels eines CAD-Programms gezeichnet und anschließend zu dem digitalen Zwilling 12 zusammengefasst werden. Dies würde eine graphische Darstellung des repräsentierten technischen Produkts 10 bedeuten, erlaubt aber keine Berücksichtigung von Eigenschaften wie zum Beispiel das Gewicht oder den Schwerpunkt des technischen Produkts 10. Zudem ist ein erneutes Anlegen solcher Objekte unnötig aufwendig, denn diese entstehen üblicherweise im Zusammenhang mit einer Entwicklung und/oder einer Fertigung des jeweiligen technischen Produkts 10 ohnehin.

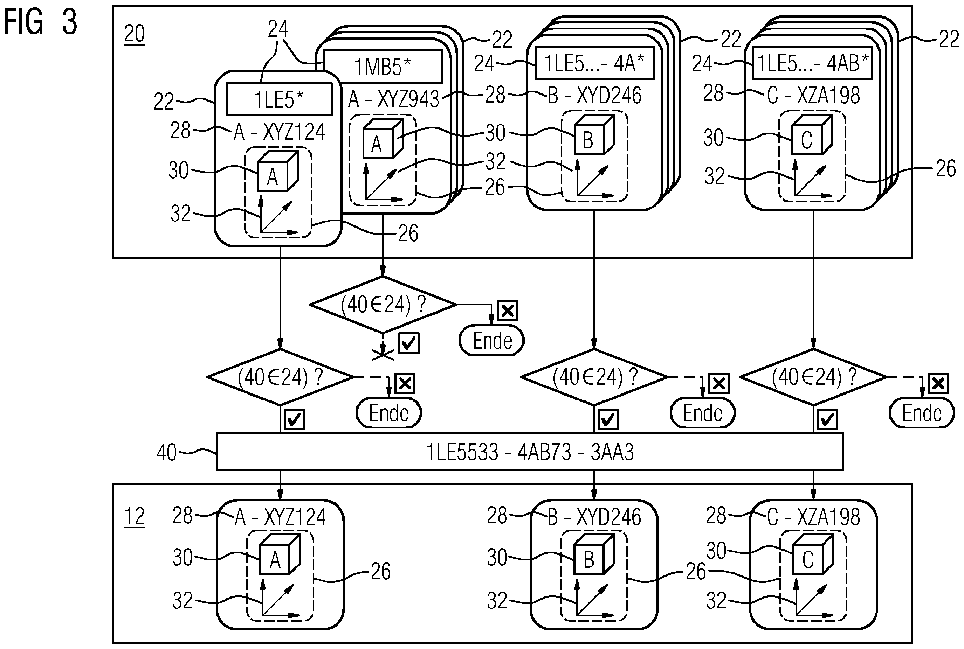

Vorteilhaft wird also für die automatische Erstellung eines digitalen Zwillings 12 auf die Daten solcher Objekte - im Folgenden als "Produktwissen" 20 (FIG 3) bezeichnet - zurückgegriffen.

Die Darstellung in FIG 3 veranschaulicht in schematisch vereinfachter Art und Weise das hier vorgeschlagene Verfahren zum Erstellen eines digitalen Zwillings 12. Ein digitaler Zwilling 12 ist ein im Zuge des Verfahrens entstehender Datensatz im Speicher eines Computers. Für die weitere Beschreibung gilt im Interesse einer besseren Lesbarkeit, dass bei einer Verwendung eines Begriffs - zum Beispiel des Begriffs "digitaler Zwilling" 12 - nicht ausdrücklich darauf hingewiesen wird, dass dies jeweils einen Datensatz im Speicher eines Computers bezeichnet. Dies ist entsprechend im Folgenden stets mitzulesen und gilt auch für andere Elemente und die diesen jeweils zugrunde liegenden Datensätze.

Der Ansatz basiert darauf, dass bereits vorhandenes Produktwissen 20 genutzt wird. Das Produktwissen 20 steht in einer automatisch verarbeitbaren Form zur Verfügung, nämlich in Form einer Datenbasis (die Datenbasis stellt das Produktwissen 20 dar und umfasst das Produktwissen 20) mit Objektvarianten 22 (Datensätze), welche jeweils eine Variante einer Komponente eines konkreten technischen Produkts 10 beschreiben. Bei einem Elektromotor als technischem Produkt 10 sind als Varianten zum Beispiel unterschiedliche Klemmenkästen denkbar, die sich hinsichtlich ihrer Geometrie und/oder hinsichtlich ihrer Position relativ zu einem Gehäuse (Ständergehäuse) des Elektromotors unterscheiden. Dann umfasst das Produktwissen 20 entsprechende Objektvarianten 22. Bei einem komplexen Produkt, wie zum Beispiel bei einem Elektromotor, kommen grundsätzlich alle davon umfassten Komponenten zur Betrachtung und Darstellung in Form von Objektvarianten 22 in Betracht (zum Beispiel Gehäuse mit oder ohne Kühlrippen, Gehäuse mit unterschiedlichen Kühlrippen, unterschiedlich lange Motorwellen usw.).

Jede Objektvariante 22 (Datensatz) umfasst eine Objektvariantenklassifikation 24. Diese fungiert als eindeutige Kennung der jeweiligen Objektvariante 22. Bevorzugt ist vorgesehen, dass eine Objektvariantenklassifikation 24 eine Objektvariante 22 nach einem alphanumerischen Regelwerk klassifiziert und sich zum Beispiel an einem Artikelcode 40 eines technischen Produkts 10 orientiert.

Jede Objektvariante 22 umfasst Objektvariantendaten 26 (Datensatz), insbesondere Objektvariantendaten 26 sowie eine eindeutige Objektvarianten-ID 28. Zu den Objektvariantendaten 26 gehören zumindest Geometriedaten 30 und Positionsdaten 32. Die Geometriedaten 30 (Datensatz) beschreiben zumindest ein geometrisches Objekt - also zum Beispiel einen Würfel, einen Zylinder oder dergleichen -, welches zu der jeweiligen Objektvariante 22 gehört. Bei einer komplexen Raumform einer Variante gehören zu der jeweiligen Objektvariante 22 eine Vielzahl von geometrischen Objekten und die Geometriedaten 30 umfassen die Gesamtheit der geometrischen Objekte.

Die Geometriedaten 30 beziehen sich auf ein lokales Koordinatensystem. Die Positionsdaten 32 beschreiben die Position der Gesamtheit der mittels der Geometriedaten 30 beschriebenen Objekte relativ zu einem jeweiligen technischen Produkt 10. Die Geometriedaten 30 beschreiben zum Beispiel zumindest ein geometrisches Objekt, welches einen Klemmenkasten eines Elektromotors repräsentiert. Die Positionsdaten 32 beschreiben dessen Position am Elektromotor, zum Beispiel oben am Ständergehäuse oder seitlich am Ständergehäuse.

Als Basis für die Spezifikation des digitalen Zwillings 12 fungiert ein Artikelcode 40. Mittels des Artikelcodes 40 wird im Rahmen des Verfahrens spezifiziert, zu welchem konkreten technischen Produkt 10 ein digitaler Zwilling 12 generiert werden soll. Ein Artikelcode 40 bezeichnet jeweils genau ein konkretes technisches Produkt 10 in einer konkreten Ausführung, also zum Beispiel einen Elektromotor einer bestimmten Leistungsstufe und mit weiteren Eigenschaften, wobei zu den weiteren Eigenschaften zum Beispiel gehört, dass der Klemmenkasten des Elektromotors seitlich angebracht ist. Der Artikelcode 40 wird im Rahmen des Verfahrens eingegeben oder aus einer Menge von Artikelcodes 40, insbesondere einer Menge angelegter Artikelcodes 40, ausgewählt.

Zum Produktwissen 20 gehören zum Beispiel auch Objektvarianten 22, welche sich auf unterschiedliche Klemmenkästen und/oder Klemmenkästen an unterschiedlichen Positionen beziehen. Jede Objektvariante 22, bei der deren Objektvariantenklassifikation 24 und der Artikelcode 40 zueinander passen, wird als zum digitalen Zwilling 12 gehörig verarbeitet, wobei jedes Objekt nur eine gültige Objektvariante 22 umfassen kann. Eine Objektvariantenklassifikation 24 passt zum Beispiel dann zu einem Artikelcode 40, wenn die Objektvariantenklassifikation 24 oder ein Teil der Objektvariantenklassifikation 24 in dem Artikelcode 40 enthalten ist. Ob die Objektvariantenklassifikation 24 oder ein Teil der Objektvariantenklassifikation 24 in dem Artikelcode 40 enthalten ist, wird zum Beispiel mittels grundsätzlich an sich bekannter Zeichenketten-Operationen (sogenannte String-Operationen) geprüft.

Bei einer alternativen Prüfmethode wird davon ausgegangen, dass die Objektvariantenklassifikation 24 in Form eines regulären Ausdrucks vorliegt. Die Objektvariantenklassifikation 24 definiert damit eine Menge. Zum Beispiel definiert eine Objektvariantenklassifikation 24 wie "1LE5*" aufgrund des als Platzhalter fungierenden Sterns eine unbegrenzte Menge von Zeichenketten, bei der jede davon umfasste Zeichenkette mit "1LE5" beginnt. Auf die Fortsetzung der Zeichenketten im Anschluss an "1LE5" kommt es nicht an. Die von der Menge umfassten Zeichenketten können beliebig lang sein, sofern sie als erste Zeichen "1LE5" umfassen und im Anschluss an "1LE5" beliebige Zeichen umfassen. Bei dieser Prüfmethode passen die Objektvariantenklassifikation 24 - also zum Beispiel "1LE5*" - und der Artikelcode 40 - zum Beispiel "1LE5533-4AB73-3AA24" zueinander, weil der Artikelcode 40 ein Element der durch die Objektvariantenklassifikation 24 definierten Menge ist.

In der Darstellung in FIG 3 ist die - bei der Ausführung des hier vorgeschlagenen Verfahrens automatisch durchgeführte - Prüfung, ob eine Objektvariantenklassifikation 24 zu einem jeweiligen Artikelcode 40 passt, in schematisch vereinfachter Art und Weise graphisch gezeigt. Die Prüfung, ob eine Objektvariantenklassifikation 24 zu dem jeweiligen Artikelcode 40 passt, ist in der Darstellung mit Bezug auf die für die Objektvariantenklassifikation 24 und den Artikelcode 40 verwendeten Bezugsziffern ausgedrückt und ist jeweils innerhalb eines Flussdiagrammsymbols für eine Verzweigung (Fallunterscheidung) als "(40∈24)?" geschrieben.

Bei der gezeigten Situation gehört der Artikelcode 40 ("1LE5533-4AB73-3AA24") zu der in Form eines regulären Ausdrucks durch die Objektvariantenklassifikation 24 "1LE5*" definierten Menge. Die Objektvariante 22 mit dieser Objektvariantenklassifikation 24 wurde folglich als zum digitalen Zwilling 12 gehörig identifiziert. Andererseits gehört der oben genannte Artikelcode 40 nicht zu der durch die Objektvariantenklassifikation 24 "1MB5*" definierten Menge. Die zugehörige Objektvariante 22 wird folglich nicht Teil des digitalen Zwillings 12. Für die anderen in FIG 3 exemplarisch gezeigten Objektvariantenklassifikationen 24 gilt dies entsprechend.

Zum automatischen Erstellen eines digitalen Zwillings 12 wird das Produktwissen 20 durchsucht. Dies bedeutet, dass alle das Produktwissen 20 bildenden Objektvarianten 22 oder eine vorgegebene oder vorgebbare Untermenge der das Produktwissen 20 bildenden Objektvarianten 22 in der oben beschriebenen Art und Weise geprüft werden. Immer dann, wenn das Ergebnis der Prüfung positiv ist, wird die zu der jeweiligen Objektvariantenklassifikation 24 gehörige (die durch die Objektvariantenklassifikation 24 bezeichnete) Objektvariante 22 als zum digitalen Zwilling 12 gehörig verarbeitet, wobei jedes Objekt nur eine gültige Objektvariante 22 umfassen kann. Diese Zugehörigkeit ist in der Darstellung in FIG 3 in Form einer Darstellung der Objektvariantendaten 26 und der Objektvarianten-ID 28 im Bereich des digitalen Zwillings 12 gezeigt.

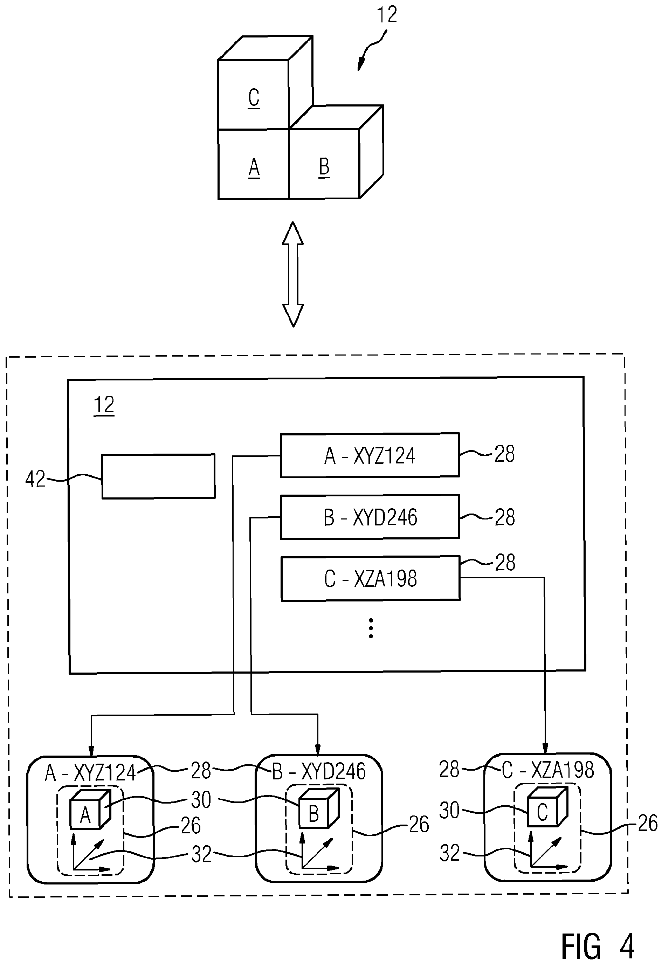

Diese Daten, also zumindest die Objektvariantendaten 26 mit den Geometriedaten 30 und die Positionsdaten 32, insbesondere die Geometriedaten 30, die Positionsdaten 32 und die Objektvarianten-ID 28, gehören nunmehr direkt oder indirekt zum digitalen Zwilling 12. Wenn die vorgenannten Daten direkt zum digitalen Zwilling 12 gehören, ist dies beispielsweise das Ergebnis eines Kopiervorgangs, bei dem die vorgenannten Daten aus der Objektvariante 22 in den digitalen Zwilling 12 kopiert wurden. Wenn die vorgenannten Daten indirekt zum digitalen Zwilling 12 gehören, umfasst der digitale Zwilling 12 zum Beispiel eine Referenzierung der Daten, zum Beispiel in Form eines sogenannten Zeigers auf die jeweilige Objektvariante 22 oder deren Objektvariantendaten 26. Eine solche Referenzierung ist schematisch vereinfacht in der Darstellung in FIG 4 gezeigt. Der digitale Zwilling 12 umfasst dann zum Beispiel eine Datenstruktur in Form von oder nach Art einer einfach oder mehrfach verketteten Liste, wobei die Elemente einer solchen Liste die jeweiligen Daten referenzieren.

Für jede auf diese Weise zum digitalen Zwilling 12 gehörig ermittelte Objektvariante 22 erfolgt eine Positionierung des oder jedes mittels der Geometriedaten 30 der jeweiligen Objektvariante 22 beschriebenen geometrischen Objekts entsprechend der Positionsdaten 32 der jeweiligen Objektvariante 22.

Damit ist der digitale Zwilling 12 erstellt. Die davon umfassten Daten können zum Beispiel, insbesondere in Form einer graphischen Darstellung der Gesamtheit der Geometriedaten 30, an einem Computermonitor angezeigt werden. Genauso können anhand der Gesamtheit der Geometriedaten 30 und der korrekten Positionierung der davon jeweils kodierten graphischen Objekte relativ zueinander automatisch ein Maßbild generiert werden und/oder ein Gewichtswert oder der Schwerpunkt ermittelt werden.

Die Darstellung in FIG 4 zeigt eine symbolische Darstellung eines digitalen Zwillings 12, wie er sich als Ergebnis des in FIG 3 veranschaulichten Verfahrens zur Generierung eines digitalen Zwillings 12 ergibt. Bei der dargestellten Situation umfasst der digitale Zwilling 12 Referenzen auf diejenigen Objektvarianten 22, die als zum digitalen Zwilling 12 gehörig ermittelt wurden (oder Referenzen auf die Objektdaten 26 derjenigen Objektvarianten 22, die als zum digitalen Zwilling 12 gehörig ermittelt wurden).

Der digitale Zwilling 12 umfasst optional einen Bezeichner 42 zu dessen Benennung. Die Benennung kann sich an dem jeweils repräsentierten technischen Produkt 10 orientieren, sodass zum Beispiel eine Benennung wie "Elektromotor 7,5kW, Klemmenkasten seitlich" in Betracht kommt.

Bei dem gewählten - extrem vereinfachten - Beispiel bedeutet der Umstand, dass der digitale Zwilling 12 mittelbar oder unmittelbar alle relevanten Daten der referenzierten Objektvarianten 22 umfasst, dass mittels der Referenzierung definiert ist, dass der digitale Zwilling 12 drei Objekte umfasst, nämlich einen ersten Würfel ("A"), einen zweiten Würfel ("B") und einen dritten Würfel ("C"). Über die von den Objektvarianten 22 umfassten Daten liegen für den digitalen Zwilling 12 unmittelbar auch deren Objektvariantendaten 26 vor. Die von den Objektvariantendaten 26 umfassten Geometriedaten 30 beschreiben die Dimension und Orientierung der einzelnen Würfel. Bei dem in FIG 1 gezeigten realen technischen Produkt 10 ist aber die Situation gegeben, dass diese Würfel miteinander verbunden sind und erst in der verbundenen Situation das technische Produkt 10 ergeben und dass zwischen den einzelnen Würfeln keine beliebige Verbindung, sondern eine konkrete Verbindung besteht, nämlich eine Verbindung derart, dass der zweite Würfel ("B") seitlich an den ersten Würfel ("A") angrenzt und dass sich der dritte Würfel ("C") auf dem ersten Würfel ("A") befindet.

Dazu liegen über die von den Objektvarianten 22 umfassten Objektvariantendaten 26 hinaus in Form der Positionsdaten 32 für jede Objektvariante 22 unmittelbar auch die Positionen der einzelnen Würfel vor. Die Positionsdaten 32 sind in den Darstellungen in FIG 3 und FIG 4 symbolisch in Form eines Koordinatensystems gezeigt. Mittels der Positionsdaten 32 wird jede als zu dem digitalen Zwilling 12 gehörig ermittelte Objektvariante 22 in einem für den digitalen Zwilling 12 geltenden Koordinatensystem positioniert. Die Positionsdaten 32 beschreiben - in grundsätzlich an sich bekannter Art und Weise - einen Versatz zwischen einem Ursprung (x=0, y=0, z=0) eines globalen Koordinatensystems des digitalen Zwillings 12 und einem Ursprung eines lokalen Koordinatensystems jeder Objektvariante 22, auf welches sich deren Geometriedaten 30 beziehen.

Mittels solcher Positionsdaten 32 kann das oder jedes durch die Geometriedaten 30 beschriebene Objekt einer Objektvariante 22 korrekt relativ zu allen Objekten jeder anderen zum digitalen Zwilling 12 gehörigen Objektvariante 22 positioniert werden. Damit ist - bezogen auf das hier gewählte einfache Beispiel - die Möglichkeit gegeben, den zweiten Würfel ("B") neben dem ersten Würfel ("A") und flächig angrenzend an den ersten Würfel zu positionieren sowie den dritten Würfel ("C") auf dem ersten Würfel ("A") zu positionieren. Für komplexere digitale Zwillinge 12 (und jeweils zugrunde liegende technische Produkte 10) gilt dies entsprechend.

Zum Beispiel repräsentiert eine Objektvariante 22, die beim gewählten Beispiel den ersten Würfel ("A") repräsentiert, anstelle eines Würfels das Ständergehäuse eines Elektromotors, eine Objektvariante 22, die beim gewählten Beispiel den zweiten Würfel ("B") repräsentiert, repräsentiert anstelle eines Würfels die Motorwelle eines Elektromotors und eine Objektvariante 22, die beim gewählten Beispiel den dritten Würfel ("C") repräsentiert, repräsentiert anstelle eines Würfels einen Klemmenkasten des Elektromotors. Auch dann werden mittels der Positionsdaten 32 die Objektvarianten 22 der einzelnen als zum digitalen Zwilling 12 gehörig identifizierten Komponenten des Elektromotors relativ zueinander korrekt positioniert.

Mit den Daten der als zum digitalen Zwilling 12 gehörig identifizierten Objektvarianten 22, speziell mit davon - zum Beispiel als Bestandteil der Geometriedaten 30 - umfassten Materialinformationen oder unmittelbaren Gewichtsinformationen, kann für den digitalen Zwilling 12 ein Gewichtswert ermittelt werden, welcher dem Gewicht des repräsentierten technischen Produkts 10 entspricht. Mit den Objektvariantendaten 26 und den Positionsdaten 32 können einerseits der Schwerpunkt und andererseits die Dimension (Länge, Breite, Höhe) des digitalen Zwillings 12 ermittelt werden. Auch diese Werte korrespondieren mit den entsprechenden Werten des repräsentierten technischen Produkts 10.

Aufgrund des Zugriffs auf das Produktwissen 20 kann der digitale Zwilling 12 leicht geändert werden und/oder es kann leicht eine Vielzahl digitaler Zwillinge 12 generiert werden. Durch Eingabe eines entsprechenden Artikelcodes 40 wird zum Beispiel ein digitaler Zwilling 12 eines Elektromotors generiert, dessen Klemmenkasten sich oben auf dem Ständergehäuse des Elektromotors befindet.

Mittels der Objektvarianten-ID 28 ist eine Verknüpfung der von einem digitalen Zwilling 12 umfassten Daten mit anderen Datenbasen möglich. Zum Beispiel kann anhand von dem digitalen Zwilling 12 umfassten Objektvarianten-IDs 28 sukzessive mittels jeweils einer Objektvarianten-ID 28 ein Zugriff auf eine Datenbasis mit Kosteninformationen erfolgen, um eine Gesamtkosteninformation zu dem durch den digitalen Zwilling 12 repräsentierten technischen Produkt 10 zu ermitteln.

Obwohl die Erfindung im Detail durch das Ausführungsbeispiel näher illustriert und beschrieben wurde, so ist die Erfindung nicht durch das oder die offenbarten Beispiele eingeschränkt und andere Variationen können vom Fachmann hieraus abgeleitet werden, ohne den Schutzumfang der Erfindung zu verlassen.

Zusammenfassend lässt sich abschließend die hier vorgeschlagenen Neuerung kurz wie folgt beschreiben: Angegeben wird ein Verfahren zum Klassifizieren von Produktwissen 20 und zum Erstellen eines als digitaler Zwilling 12 eines technischen Produkts 10 fungierenden Softwareobjekts auf Basis von gegebenen Produktwissen 20, wobei das Produktwissen 20 in einer automatisch verarbeitbaren Form zur Verfügung steht und als Objektvarianten 22 Datensätze mit Daten für Varianten zumindest einer Komponente des technischen Produkts 10 umfasst, wobei den Objektvarianten 22 jeweils eine als eindeutige Kennung fungierende Objektvariantenklassifikation 24 sowie Geometriedaten 30 und Positionsdaten 32 zugeordnet sind, wobei jede Objektvariante 22, deren Objektvariantenklassifikation 24 zu einem vorgegebenen oder vorgebbaren Artikelcode 40 passt, als zum digitalen Zwilling 12 gehörig verarbeitet wird und wobei für jede zum digitalen Zwilling 12 gehörige Objektvariante 22 eine Positionierung des oder jedes mittels der Geometriedaten 30 der jeweiligen Objektvariante 22 beschriebenen geometrischen Objekts entsprechend der Positionsdaten 32 der jeweiligen Objektvariante 22 erfolgt.

## Patentansprüche

1. Verfahren zum automatischen Erstellen eines als digitaler Zwilling (12) eines technischen Produkts (10) fungierenden Softwareobjekts auf Basis von gegebenen Produktwissen (20), wobei das Produktwissen (20) in einer automatisch verarbeitbaren Form zur Verfügung steht und als Objektvarianten (22) Datensätze mit Daten für unterschiedliche Varianten zumindest einer Komponente des technischen Produkts (10) umfasst,
wobei den Objektvarianten (22) jeweils eine als eindeutige Kennung fungierende Objektvariantenklassifikation (24) zugeordnet ist,
wobei den Objektvarianten (22) jeweils Geometriedaten (30) und Positionsdaten (32) zugeordnet sind,
wobei jede Objektvariante (22), bei der deren Objektvariantenklassifikation (24) und ein vorgegebener oder vorgebbarer Artikelcode (40) zueinander passen, als zum digitalen Zwilling (12) gehörig verarbeitet wird,
wobei für jede zum digitalen Zwilling (12) gehörige Objektvariante (22) eine Positionierung des oder jedes mittels der Geometriedaten (30) der jeweiligen Objektvariante (22) beschriebenen geometrischen Objekts entsprechend der Positionsdaten (32) der jeweiligen Objektvariante (22) erfolgt.

2. Verfahren nach Anspruch 1, wobei die Objektvariantenklassifikation (24) in Form eines eine Menge definierenden Ausdrucks in einer formalen Sprache vorliegt und wobei eine Objektvariantenklassifikation (24) und ein Artikelcode (40) als zueinander passend ausgewertet werden, wenn der Artikelcode (40) Element der durch die Objektvariantenklassifikation (24) definierten Menge ist.

3. Verfahren nach Anspruch 1 oder 2, wobei unter Berücksichtigung aller zum digitalen Zwilling (12) gehörigen Objektvarianten (22) automatisch ein Gewichtswert und/oder ein Schwerpunkt ermittelt wird.

4. Verfahren nach Anspruch 1, 2 oder 3, wobei unter Berücksichtigung aller zum digitalen Zwilling (12) gehörigen Objektvarianten (22) automatisch ein Maßbild generiert wird.

5. Verfahren nach einem der vorangehenden Ansprüche, wobei zum Erhalt einer Beschreibung des digitalen Zwillings (12) des technischen Produkts (10) relevante Objektvariantendaten (26) aller als zum digitalen Zwilling (12) gehörig ermittelter Objektvarianten (22) gespeichert werden.

6. Computerprogramm mit Programmcodemitteln, um alle Schritte von jedem beliebigen der Ansprüche 1 bis 5 durchzuführen, wenn das Computerprogramm auf einem Computer ausgeführt wird.

7. Digitales Speichermedium mit elektronisch auslesbaren Steuersignalen, die so mit einem Computer zusammenwirken können, dass ein Verfahren nach einem der Ansprüche 1 bis 5 ausgeführt wird.
